# EUROPÄISCHE PATENTSCHRIFT

(11) **EP 2 925 096 B1**
(45) Veröffentlichungstag und Bekanntmachung des Hinweises auf die Patenterteilung: **22.11.2017**
(21) Anmeldenummer: 14194693.9
(22) Anmeldetag: 25.11.2014
(51) Int. Cl.: H05B 37/02, G05D 25/02, G06F 3/01, G06F 3/044

(54) **Verfahren zum Ansteuern einer elektrischen Last, etwa einer Beleuchtungseinrichtung**
Method for controlling an electric load, such as a lighting device
Procédé de commande d'une charge électrique ou d'un dispositif d'éclairage

(30) Priorität: 24.01.2014 DE 102014100808
(43) Veröffentlichungstag der Anmeldung: 30.09.2015
(73) Patentinhaber: Insta GmbH, 58509 Lüdenscheid (DE)
(72) Erfinder: Neuhaus, Stefan, 44287 Dortmund (DE); Ziefuss, Heiko, 58644 Iserlohn (DE)

(56) Entgegenhaltungen:
- US-A1- 2009 195 166
- Microchip: "Single-Zone 3D Gesture Controller Data Sheet", , 11. Dezember 2012 (2012-12-11), Seiten 1-40, XP055054982, INET Gefunden im Internet: URL:http://ww1.microchip.com/downloads/en/ DeviceDoc/41667A.pdf [gefunden am 2013-03-01]

## Beschreibung

Die Erfindung betrifft ein Verfahren zum Ansteuern einer elektrischen Last, beispielsweise einer Beleuchtungseinrichtung einer Gebäudeinstallation, mittels eines berührungslos arbeitenden Gestenerkennungssensors mit den Merkmalen des Oberbegriffs des Anspruchs 1.

Elektrische Lasten, vor allem wenn diese Teil einer Gebäudeinstallation sind, wie beispielsweise eine Beleuchtungseinrichtung oder Teile derselben werden über Sensoren angesteuert. Angesteuert werden mit derartigen Sensoren der oder die Aktoren einer Gebäudeinstallation, also beispielsweise eine Beleuchtungseinrichtung in aller Regel nicht unmittelbar, sondern unter Zwischenschaltung von Steuerungsmitteln. In aller Regel ist die anzusteuernde Gebäudeinstallation an einen Bus angeschlossen. Gleiches gilt für den oder die Sensoren. Somit kommuniziert in aller Regel ein solcher Sensor über das Bussystem und über die die Kommunikation in dem Bussystem steuernde Logik die jeweilige Gebäudeinstallation. Mit diesen Sensoren kann die Beleuchtungseinrichtung ein- und ausgeschaltet werden. Bei entsprechender Eignung des Sensors kann diese auch gedimmt und somit auch mit reduzierter Leistung angesteuert werden. Taster und Dimmer als Sensoren sind in unterschiedlichen Ausgestaltungen vorbekannt, auch in einer Ausgestaltung, bei der diese als in ein als Touchscreen konzipiertes Bedienpaneel eingebunden sind. Erforderlich ist bei diesen Sensoren, dass diese zum Ansteuern der elektrischen Last berührt werden müssen. Es gibt zahlreiche Anwendungsfälle, bei denen eine berührungslose Sensorbetätigung wünschenswert wäre. Eine berührungslose Sensorbetätigung ist beispielsweise in hygienischen Umgebungen, wie etwa in Krankenhäusern oder dergleichen gewünscht. Sinnvoll ist eine berührungslose Sensorbetätigung jedoch auch überall dort, wo Verschmutzungen an Schaltern oder dergleichen vermieden werden sollen.

Berührungslos arbeitende Gestenerkennungssensoren sind ebenfalls vorbekannt. Ausgeführt sind diese beispielsweise als elektrische Nahfeldsensoren, bei denen eine Gestenerkennung mit einem Gestikgeber, beispielsweise der Hand einer Person eine Veränderung des elektrischen Feldes herbeigeführt wird. Derartige Sensoren erlauben eine Gestenerfassung in der Ebene des Sensors ebenso wie eine Abstandsdetektion.

Aus EP 0 722 262 A2 ist ein optisch arbeitender Dimmer bekannt. Dieser umfasst einen mit Infrarottechnologie arbeitenden Abstandssensor. In Abhängigkeit von dem Abstand einer Hand als Gestikgeber von dem IR-Abstandssensor wird die elektrische Last angesteuert. Schwierigkeiten bereitet es jedoch, wiederholbare Dimmergebnisse zu erzielen, was darin begründet liegt, dass sich der Gestikgeber bei einer gewünschten Betätigung der Dimmeinrichtung wohl immer in einem unterschiedlichen Abstand zu dem Gestenerkennungssensor befinden wird.

Ein Verfahren zum Ansteuern einer elektrischen Last mittels eines berührungslos arbeitenden Gestenerkennungssensors ist aus US 2009/0195 166 A1 bekannt. Bei diesem vorbekannten Verfahren wird mittels Sensoren überprüft, ob entlang einer Gestenbahn, die durch vorbestimmte Punkte innerhalb des Erfassungsbereiches der Sensoren definiert ist, in einem ebenfalls vorgegebenen zeitlichen Abstand der Gestikgeber über diese Punkte geführt wird. Ist ein Gestikgeber über eine vorgegebene Gestenbahn geführt worden, wird dieses als Betätigungssignal interpretiert und die gewünschte Lastansteuerung vorgenommen. Mit diesem vorbekannten Verfahren lässt sich eine Last, wobei als Last eine Beleuchtungseinrichtung vorgesehen ist, in vordefinierte Zustände ein- und ausschalten. Eine Einstellung des Betriebs der Last mittels einer Gestenbewegung ist bei diesem Stand der Technik nicht möglich. Um die Beleuchtungseinrichtung zu dimmen oder eine Farbänderung vorzunehmen, wird gemäß diesem Verfahren, nachdem durch eine entsprechende Geste die Einrichtung in einen Dimmmodus geschaltet worden ist, steuergeräteseitig die Helligkeit geändert, bis benutzerseitig durch eine entsprechende Geste dieser Modus beendet wird.

Ausgehend von dem vorstehend diskutierten Stand der Technik liegt der Erfindung daher die Aufgabe zugrunde, ein Verfahren zum Ansteuern einer elektrischen Last, insbesondere einer elektrischen Last im Rahmen einer Gebäudeinstallation, wie etwa einer Beleuchtungseinrichtung vorzuschlagen, mit dem eine Ansteuerung nicht nur vereinfacht und grundsätzlich mit unterschiedlichen Technologien arbeitenden Sensoren realisierbar ist, sondern bei dem eine Bedienung intuitiv seitens des Benutzers vorgenommen werden kann und somit die Last, also beispielsweise die Beleuchtungseinrichtung, unmittelbar über eine durchgeführte Geste ansteuerbar ist.

Gelöst wird diese Aufgabe erfindungsgemäß durch ein eingangs genanntes Verfahren, welches folgenden weiteren Schritt umfasst:
- Bestimmen der Einstiegsposition des erfassten Gestikgebers auf einer für die Ansteuerung der elektrischen Last vorgesehenen und auf die Ebene des Gestenerkennungssensors projizierte Bahn, entlang der der Gestikgeber zum Ändern der aktuellen Einstellung der elektrischen Last bewegt werden muss - einer Gestenbahn - und
- Bereitstellen jeweils einer Stellwertskennlinie von einem vorgegebenen Einstellwert zu einem Minimalwert oder zu einem Maximalwert - einer Stellrampe - von dem vorgegebenen Einstellwert zu einem Minimalwert sowie von dem vorgegebenen Einstellwert zu einem Maximalwert in Abhängigkeit von einer Einstiegsposition des Gestikgebers auf der Gestenbahn.

Die Besonderheit dieses Verfahrens liegt darin, dass es für die Ansteuerung der elektrischen Last unerheblich ist, an welcher Position - der Einstiegsposition - innerhalb einer vorgegebenen Gestenbahn der Gestikgeber erfasst wird. Die Gestenbahn ist diejenige vorgegebene und auf die Ebene des Sensors projizierte Bahn, entlang der der Gestikgeber zum Ändern der aktuellen Einstellung der elektrischen Last bewegt werden muss. Hierbei kann es sich um eine Bewegung in der Ebene des Sensors, falls als Flächensensor ausgebildet, beispielsweise ausgeführt als Kreisbewegung, als bogenförmige Bewegung oder als translatorische Bewegung, oder um eine Bewegung, durch die der Abstand des Gestikgebers von dem Gestenerkennungssensor verändert wird. Im letzteren Falle ist der Gestenerkennungssensor mit einer Abstandsbestimmungsfunktionalität ausgestattet.

Ausgehend von der Einstiegsposition des Gestikgebers innerhalb der Gestenbahn werden Stellrampen eingerichtet bzw. bereitgestellt, und zwar eine Stellrampe von dem der Einstiegsposition zugehörigen Einstellwert zu einem Minimalwert und eine weitere Stellrampe von dem der Einstiegsposition zugehörigen Einstellwert zu einem Maximalwert gemäß denen der Einstellwert bei Bewegen des Gestikgebers verändert wird. Die Stellrampen können stetig oder auch nicht stetig ausgeführt sein. Im ersteren Falle kann eine solche Stellrampe linear oder eine gekrümmte Bahn aufweisen. Im letzteren Fall wird man diese stufig ausbilden, das heißt: die Änderung in der Einstellung der Gebäudeinstallation ändert sich entsprechend der einen oder der mehreren Stufen der Stellrampe. Die Ausbildung der Stellrampe kann auch in Abhängigkeit von der anzusteuernden elektrischen Last, also beispielsweise in Abhängigkeit von dem oder den in einer Beleuchtungseinrichtung verwendeten Leuchtmitteln eingerichtet werden. Hat beispielsweise ein Leuchtmittel keine lineare Dimmcharakteristik, kann dieses durch entsprechende Konfigurierung der Stellrampe ausgeglichen werden, um benutzerseitig über die Bewegung des Gestikgebers ein einheitliches Änderungsverhalten zu erzielen. Der erste Einstellwert ist vorgegeben. Je nach Art der elektrischen Last kann es sich hierbei um den Minimalwert, den Maximalwert oder um jeden beliebigen dazwischen liegenden Wert handeln. Der Einstiegswert kann als konstante Größe vorgegeben sein. Bei einer anderen Ausgestaltung wird als Einstellwert derjenige Wert der Einstellung der elektrischen Last verwendet, mit dem die elektrische Last vor dem letzten Ausschalten angesteuert worden ist. Dieses bietet sich vor allem dann an, wenn eine Einstellung in der Ansteuerung der elektrischen Last vorgenommen werden soll, wenn diese mit einem bestimmten Einstellwert bereits angesteuert ist. Durchaus möglich ist es auch, den ersten Einstellwert in Abhängigkeit von anderen Faktoren vorzugeben. Handelt es sich bei der anzusteuernden Gebäudeinstallation beispielsweise um eine Beleuchtungseinrichtung, kann der erste Einstellwert in Abhängigkeit etwa von der Umgebungshelligkeit vorgegeben werden. Sind die Stellrampen eingerichtet, erfolgt eine Änderung in der Einstellung der elektrischen Last entsprechend der Bewegung des Gestikgebers entlang der Gestenbahn. In aller Regel wird sich die Einstiegsposition des Gestikgebers zwischen den beiden Endpunkten der Gestenbahn befinden. In einem solchen Fall wird bei Bewegen des Gestikgebers in die eine Richtung die elektrische Last mit geringerer und bei Bewegen in die andere Richtung mit größerer Leistung angesteuert, und zwar entsprechend der in Abhängigkeit von der Einstiegsposition des Gestikgebers auf der Gestenbahn zwischen den beiden Endpunkten eingerichteten Stellrampen. Berücksichtigt wird bei diesem Konzept, dass die Gestenbahn eine vorgegebene Erstreckung hat, so dass in Abhängigkeit von der Position des Einstiegs des Gestikgebers zwischen den beiden Endpunkten die Stellrampen eine dementsprechend unterschiedliche Steilheit aufweisen. In aller Regel werden die Stellrampen von der Einstiegsposition zu den beiden jeweiligen Endpunkten der Gestenbahn unterschiedlich sein.

Die Intuition in der Ansteuerung der elektrischen Last, beispielsweise der Beleuchtungseinrichtung einer Gebäudeinstallation liegt darin begründet, dass unabhängig von der Position des Einstiegs des Gestikgebers, also: beispielsweise der Hand eines Nutzers, innerhalb der Gestenbahn eine vorgegebene Einstellung der elektrischen Last erfolgt. Bei einer Beleuchtungseinrichtung wird somit diese mit einem vorgegebenen Einstellwert angesteuert, beispielsweise 75 % der maximalen Leistung. Um die Beleuchtungseinrichtung an die gewünschte Helligkeit anzupassen wird sodann der Gestikgeber in die eine oder in die andere Richtung entlang der Gestenbahn bewegt, je nachdem, ob die mit einer Ansteuerung von 75 % erzielte Helligkeit erhöht oder erniedrigt werden soll. Ist die Gestenbahn eine Abstandsfunktion zu dem Gestenerkennungssensor wird der Gestikgeber für eine Änderung des Einstellwertes somit entweder zu dem Gestenerkennungssensor hin oder von diesem weg bewegt. Entsprechend der an die Einstiegsposition geknüpften Stellrampen wird durch diese Bewegung die Helligkeit geändert. Ist der Gestikgeber zum Einstellen der gewünschten Helligkeit in die falsche Richtung bewegt worden, wird dieses von dem Nutzer unmittelbar beobachtet, so dass er intuitiv den Gestikgeber in die entgegengesetzte Richtung bewegen wird. Auf diese Weise ist eine intuitive Ansteuerung einer elektrischen Last, insbesondere einer Gebäudeinstallation wie etwa einer Beleuchtungseinrichtung möglich. Es versteht sich, dass eine Rückmeldung in geeigneter Weise durch den angesteuerten Aktor an den Nutzer erforderlich ist. Im Falle des Ansteuerns einer Beleuchtungseinrichtung ist dieses durch die mit einer Änderung der Position des Gestikgebers auf der Gestenbahn bewirkte Helligkeitsänderung ohne Weiteres möglich. Gleichermaßen ist dieses auch bei anderen Gebäudeinstallationen, wie beispielsweise der Stellung von Jalousien, Rollos, Sonnenblenden oder dergleichen möglich.

Dieses Konzept hat zur Folge, dass, wenn sich die Einstiegsposition des Gestikgebers in einer Position auf der Gestenbahn befindet und wenn der vorgegebene Einstellwert weder dem Minimalwert noch dem Maximalwert entspricht, die zu dem nächstliegenden Endpunkt der Gestenbahn führende Stellrampe in aller Regel sehr viel steiler ist als die andere. Um die Auflösung in der Einstellbarkeit der elektrischen Last auch unter Verwendung der steileren Stellrampe zu verbessern, ist in einer bevorzugten Weiterbildung vorgesehen, dass bei Feststellen einer Änderung in der Bewegungsrichtung des Gestikgebers bei dem Vorgang des Änderns der Einstellung der elektrischen Last die Position der Bewegungsrichtungsänderung auf der Gestenbahn eine neue Einstiegsportion darstellt und ausgehend von dem dieser neuen Einstellposition entsprechenden Einstellwert jeweils eine Stellrampe zu dem Minimalwert und zu dem Maximalwert eingerichtet werden und dass bei weiterem Bewegen des Gestikgebers in der geänderten Bewegungsrichtung die Einstellung der elektrischen Last entsprechend der neu eingerichteten Stellrampe geändert wird. Bei dieser Auslegung des Verfahrens wird die Einstiegsposition des Gestikgebers in Bezug auf die gewünschte Einstell- bzw. Dimmrichtung gegenüber der ursprünglichen Einstiegsposition verschoben, und zwar in eine Richtung, dass eine Bewegung des Gestikgebers in die geänderte Bewegungsrichtung zu einer Einstellwertänderung entsprechend der nunmehr flacheren Stellrampe erfolgt. Der Betrag der Verschiebung der Einstiegsposition des Gestikgebers wird typischerweise durch den Nutzer selbst vorgenommen, und zwar indem er den Punkt der Bewegungsrichtungsänderung des Gestikgebers vorgibt. Typischerweise würde es sich bei einer solchen Bewegungsänderung für die vorgenannten Zwecke um eine Bewegungsumkehr handeln.

Ausgelegt werden kann die Ansteuerung der elektrischen Last über die eingerichteten Stellrampen auch derart, dass eine Änderung in der Einstellung bzw. Ansteuerung der elektrischen Last unmittelbar an die von dem Gestenerkennungssensor erfasste Bewegung des Gestikgebers auf der Gestenbahn gekoppelt ist. Die Geschwindigkeit des Bewegens des Gestikgebers beeinflusst sodann auch die Geschwindigkeit der Änderung der Einstellung. Gemäß einer anderen Ausgestaltung ist vorgesehen, die Ansteuerungsänderung bzw. die Änderung in der Ansteuerung der elektrischen Last dynamisch auszuführen. Bei einer solchen Ausgestaltung wird gemäß einem Ausführungsbeispiel die Geschwindigkeit in der Änderung der Ansteuerung in Abhängigkeit von der betragsmäßigen Positionsänderung zwischen der Einstiegsposition und einer zweiten, hiervon beabstandeten Position des Gestikgebers vorgenommen. Typischerweise wird man bei einer solchen Verfahrensausgestaltung bei kleineren Positionsänderungen die Geschwindigkeit in der Änderung der Ansteuerung ebenfalls gering wählen, während als Folge einer größeren Positionsänderung zwischen der Einstiegsposition des Gestikgebers und einer zweiten Position eine raschere Einstellungsänderung der elektrischen Last erfolgt.

Um die eingerichtete Einstellung zu halten, wird von dem Gestikgeber ein Halte-Signal erzeugt. Dieses ist vordefiniert. Hierfür stehen verschiedene Möglichkeiten zur Verfügung. Ein solches Halte-Signal lässt sich durch den Gestikgeber beispielsweise durch Halten desselben in derjenigen Position, in der der Aktor mit der gewünschten Einstellung angesteuert wird, über eine gewisse Zeitspanne hinweg. Möglich ist es auch, den Gestikgeber aus der Bewegungsbahn herauszubewegen. Typischerweise wird dieses als Herausführen des Gestikgebers aus dem Erfassungsbereich des Gestenerkennungssensors realisiert sein, und zwar quer zur Erstreckung der Gestenbahn. Vorzugsweise wird man ein solches Halte-Signal derart definieren, dass es sich hierbei um eine eher rasche Bewegung handelt. Ein Halte-Signal kann beispielsweise auch durch eine kurzzeitige Bewegungsumkehr des Gestikgebers im Zuge seiner Bewegung auf der Gestenbahn erzeugt werden. Zur Unterscheidung, dass bei einer solchen Bewegungsumkehr keine neue Einstiegsposition definiert werden soll, sondern dieses als Halte-Signal auszuwerten ist, kann dadurch herbeigeführt werden, dass sich an die ein Halte-Signal erzeugende Bewegungsumkehr innerhalb eines vorgegebenen Zeitintervalls keine weitere Bewegung des Gestikgebers in dieser Richtung erfasst wird. Für die Zwecke des Erzeugens eines Halte-Signals gemäß diesem Algorithmus ist letztendlich jedoch unerheblich, ob durch die Bewegungsumkehr eine neue Einstiegsposition definiert wird oder nicht.

Weitere Vorteile und Ausgestaltungen der Erfindung ergeben sich aus der nachfolgenden Beschreibung von Ausführungsbeispielen unter Bezugnahme auf die beiliegenden Figuren. Es zeigen:
- **Fig. 1:**: eine schematisierte Ansicht eines Ausschnittes einer Gebäudewand mit einer darin eingebauten Einrichtung zum Ansteuern der Beleuchtung, welche Einrichtung einen Gestenerkennungssensor umfasst,
- **Fig. 2:**: einen schematisierten Querschnitt durch den Gestenerkennungssensor und den ihm zugeordneten Erfassungsbereich (oben) sowie Ansteuerungskurven zum Ansteuern der Beleuchtungseinrichtung in Abhängigkeit von der Position eines erfassten Gestikgebers (unten) und
- **Fig. 3:**: eine schematisierte Draufsicht auf einen weiteren Gestenerkennungssensor als Teil einer Einrichtung zum Ansteuern einer Beleuchtungseinrichtung eines Gebäudes, vorgesehen zum Ansteuern der Beleuchtungseinrichtung über eine andere Gestenbahn.

Benachbart zu einem Türdurchbruch 1 innerhalb einer Wand 2 eines im Übrigen nicht näher dargestellten Gebäudes befindet sich ein Sensor 3 zum Ansteuern einer nicht dargestellten Beleuchtungseinrichtung. Die Beleuchtungseinrichtung befindet sich innerhalb des Raumes, der durch den Türdurchbruch 1 verlassen oder umgekehrt betreten werden kann. Der Sensor 3 ist Teil einer weitere Komponenten umfassenden Einrichtung zum Ansteuern der Beleuchtungseinrichtung. Diese umfassen die üblichen, hierzu notwendigen Komponenten, wie ein Bus-System, eine Buslogik und dergleichen, auf die es im Rahmen dieser Ausführungen nicht ankommt.

Bei dem Sensor 3 handelt es sich um einen berührungslos betätigbaren Sensor, sodass die Beleuchtungseinrichtung durch Beaufschlagen des Sensors 3 mit einer entsprechenden Gestik angesteuert werden kann. Dieses beinhaltet nicht nur ein Ein- und Ausschalten der Beleuchtungseinrichtung, sondern auch ein Dimmen derselben.

Bei dem dargestellten Ausführungsbeispiel ist der Gestenerkennungssensor 3 als elektrischer Nahfeldsensor ausgelegt. Derartige Sensoren sind hinlänglich bekannt. Ein solcher Sensor wird beispielsweise von der Firma Microchip unter der Typenbezeichnung MGC3130 vertrieben. Aufgrund der Konzeption des Sensors 3 des dargestellten Ausführungsbeispiels kann dieser als Abstandssensor oder auch als Flächensensor zur ortsaufgelösten Positionsbestimmung eines Gestikgebers eingesetzt werden.

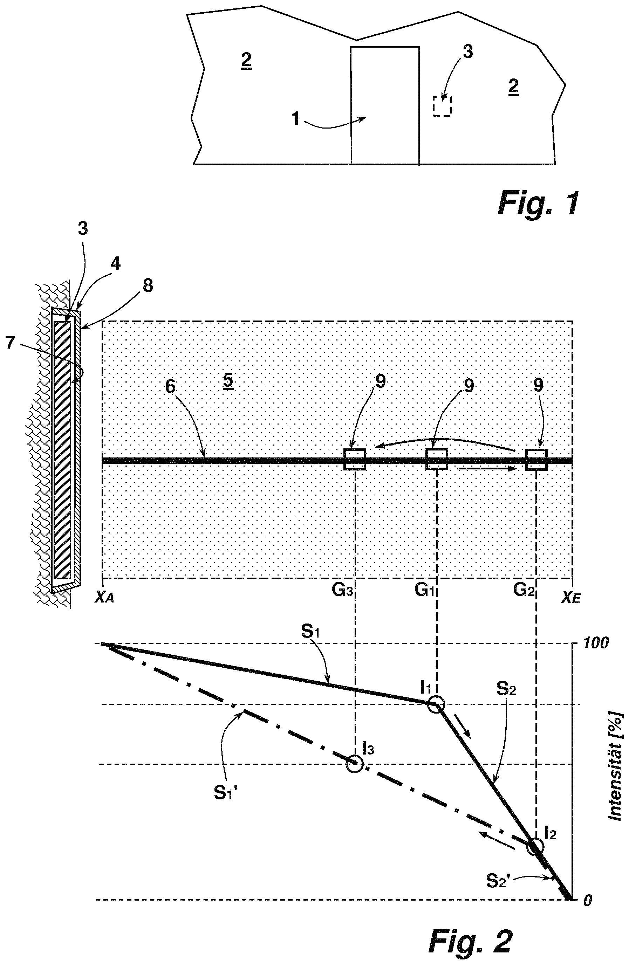

In Figur 2 ist der Gestenerkennungssensor 3 in einem schematisierten Querschnitt in seiner Einbauanordnung gezeigt. Der Sensor 3 ist wandseitig verbaut. Seine in den Raum gerichtete sensitive Vorderseite ist durch eine Abdeckung 4 verblendet. Der Erfassungsbereich des Sensors 3 ist in Figur 2 schematisiert durch das punktgerasterte Feld und mit dem Bezugszeichen 5 kenntlich gemacht. Eingetragen ist in den Erfassungsbereich 5 eine Gestenbahn 6. Bei dem dargestellten Ausführungsbeispiel verläuft die Gestenbahn 6 orthogonal zur Erfassungsebene 7 des Sensors 3. Die Gestenbahn 6 stellt diejenige Bahn dar, auf der ein Gestikgeber zu bewegen ist, um die Beleuchtungseinrichtung einzustellen. Die orthogonale Ausrichtung der Gestenbahn 6 zu der Ebene 7 des Sensors 3 bedeutet bei dem dargestellten Ausführungsbeispiel, dass der Sensor 3 für die diesbezügliche Gestenerkennung als Abstandssensor arbeitet.

Bei dem im Rahmen dieser Ausführungen benutzten Begriff der Gestenbahn handelt es sich um diejenige Bewegungsbahn, auf der ein Gestikgeber zu bewegen ist, wenn eine Ansteuerung der Beleuchtungseinrichtung gewünscht wird. Dabei werden Änderungen in der Position eines Gestikgebers als Projektion auf die Erfassungsebene 7 des Sensors 3 ausgewertet. Die Gestenbahn 6 stellt somit die in die Ebene 7 des Sensors 3 projizierte Bewegungsbahn eines Gestikgebers dar.

Bei dem in den Figuren 1 und 2 dargestellten Ausführungsbeispiel, bei dem die Gestenbahn 6 orthogonal zu der Ebene 7 des Sensors 3 verläuft, spielt es für die Erfassung einer Geste, vorgesehen zum Ansteuern der Beleuchtungseinrichtung, keine Rolle, ob der Gestikgeber 9 in seiner Projektion die gesamte Ebene 7 des Sensors 3 bedeckt oder nur einen Teil hiervon. Um Fehlansteuerungen zu vermeiden, ist in einer Ausgestaltung vorgesehen, die Position nur solcher Gestikgeber 9 zu berücksichtigen, die eine bestimmte Fläche der Erfassungsebene 7 des Sensors 3 in ihrer Projektion darauf bedecken. Bei dem in den Figuren dargestellten Ausführungsbeispiel ist in Bezug auf diese Maßnahme vorgesehen, dass eine Bedeckung der Erfassungsebene 7 von mindestens 70 % durch den Gestikgeber 9 vorliegen muss, damit eine Beleuchtungseinrichtungsansteuerung möglich ist. Diese Bedeckung der Erfassungsebene 7 muss nicht notwendigerweise durch eine durchgehende Fläche bewirkt sein. Hierbei kommt es zumindest bei dem dargestellten Ausführungsbeispiel nur auf den Gesamtbetrag der bedeckten Erfassungsebene 7 an. Daher kann die Beleuchtungseinrichtung auch über den Sensor 3 angesteuert werden, wenn dessen Erfassungsebene 7 nur von mehreren, auf Abstand gehaltenen Fingern als Gestikgeber 9 bedeckt ist, solange die bei diesem Ausführungsbeispiel vorgesehene Voraussetzung erfüllt ist, dass zumindest 70 % der Erfassungsebene 7 in der Projektion eines solchen Gestikgebers 9 bedeckt sind. Die vorstehenden Ausführungen zur Bedeckung der Erfassungsebene 7 des Sensors 3 gelten vorzugsweise auch für solche Ausgestaltungen, bei denen die Gestenbahn 6 anders ausgelegt ist, etwa als Kreisbewegung oder als translatorische Bewegung. Als mögliche weitere oder auch alternative Maßnahme zum Detektieren gewünschter Sensorbetätigungen kann vorgesehen sein, dass ein Gestikgeber 9 erst dann als solcher erkannt wird, wenn dieser in seiner erfassten Position für eine gewisse Zeitspanne verbleibt.

Eine Ansteuerung der Beleuchtungseinrichtung mittels des Gestenerkennungssensors 3 als Teil der Beleuchtungsansteuerungseinrichtung ist nachfolgend unter Bezugnahme auf die Diagramme der Figur 2 beschrieben. Alles, was eine Person zum zielgerichteten Ansteuern der Beleuchtungseinrichtung wissen sollte, ist der Verlauf der Gestenbahn. Bei dem dargestellten Ausführungsbeispiel bedeutet dieses, dass eine solche Person den Gestikgeber 9, beispielsweise ihre Hand unter Veränderung des Abstandes zu der Oberfläche 8 der Abdeckung 4 zu bewegen hat, wenn eine Änderung in der Einstellung vorgenommen werden soll. Bei dem dargestellten Ausführungsbeispiel ist vorgesehen, dass nach Erfassen eines Gestikgebers 9 innerhalb des Erfassungsbereiches 5 des Sensors 3 zum Zwecke einer Ansteuerung der Beleuchtungseinrichtung, diese, falls ausgestaltet, mit einem vorgegebenen Einstellwert, der bei diesem Beispiel 75 % der Maximalintensität entspricht, eingeschaltet wird. In Figur 2 ist diese Einstiegsposition des Gestikgebers 9 zwischen den beiden Endpunkten X_{A}, X_{E} der Gestenbahn 6 mit G₁ angegeben. In dieser Einstiegsposition des Gestikgebers 9 bedeckt dieser mehr als 70 % der Erfassungsebene 7 des Sensors 3. Die Beleuchtungseinrichtung wird, wie auf dem Diagramm in Figur 2 unten erkennbar, mit dem vorgegebenen Einstellwert, hier: der vorgegebenen Einschaltintensität I₁ angesteuert. Im Zusammenhang mit diesem Vorgang wird die Position des Gestikgeber 9 auf der Gestenbahn 6 zwischen den beiden Endpunkten X_{A}, X_{E} bestimmt. Dieses kann gleichzeitig mit dem Einschalten der Beleuchtungseinrichtung, zeitlich vor dem Einschalten oder auch nach dem Einschalten vorgenommen werden. Nach Bestimmen der Einstiegsposition des Gestikgebers 9 auf der Gestenbahn 6, also: der Position G₁, werden Stellrampen eingerichtet, entlang denen bei einer Bewegung des Gestikgebers 9 in die eine oder in die andere Richtung entlang der Gestenbahn 6 die Intensitätsansteuerung der Beleuchtungseinrichtung vollzogen wird. Somit wird eine erste Stellrampe - die Stellrampe S₁ - eingerichtet, die von der der Einstiegsposition G₁ entsprechenden Intensität - hier: Einschaltintensität 75 % - zu dem Maximalintensitätswert am Endpunkt X_{A} der Gestenbahn 6 und eine weitere Stellrampe S₂ eingerichtet, die die Beleuchtungsintensität in der Einstiegsposition G₁ mit der Minimalintensität am anderen Endpunkt X_{E} der Gestenbahn 6 verbindet. Bei dem dargestellten Ausführungsbeispiel ist der Minimalwert mit 0 % Intensität und der Maximalwert mit 100 % Intensität angegeben. Es versteht sich, dass diese Endpunkte auch anders ausgelegt sein können. Aufgrund der Anordnung der Einstiegsposition G₁ auf der Gestenbahn 6 ist die Steigung der Stellrampe S₁ kleiner als die Steigung der Stellrampe S₂. Dieses führt dazu, dass eine Bewegung des Gestikgebers 9 Richtung zu der Abdeckung 4 bei gleichem Weg wie bei einer umgekehrten Bewegung des Gestikgebers 9 von der Abdeckung 4 weg eine geringere Änderung in der Beleuchtungsintensität zur Folge hat.

Entspricht der Einstellwert, mit dem die Beleuchtungseinrichtung nach erstmaligem Erfassen des Gestikgebers 9 angesteuert wird, nicht der gewünschten Helligkeit, wird der Nutzer intuitiv seine Hand, die er in diesem Fall als Gestikgeber 9 benutzt, entweder zu der Abdeckung 4 hin oder von dieser wegbewegen. Entspricht die sich infolge einer solchen Positionsänderung des Gestikgebers 9 ändernde Helligkeit der Beleuchtung nicht der gewünschten Intensitätsänderungsrichtung, wird der Nutzer intuitiv diese Bewegung umkehren und dann innehalten, wenn die gewünschte Intensität erreicht ist.

Bei dem vorbeschriebenen Ausführungsbeispiel ist als Einstellwert vorgesehen, die Beleuchtungseinrichtung mit einer Intensität von 75 % anzusteuern, wenn diese ausgeschaltet war. Es versteht sich, dass letztendlich jeder beliebige Einstellwert vorgegeben werden kann. Auch ist es möglich, auf einen fest vorgegeben Einstellwert auch dann zurückzugreifen, wenn die Beleuchtungseinrichtung bereits eingeschaltet ist. Um jedoch rasche Sprünge in der Intensitätsänderung zu vermeiden, beispielsweise wenn die Beleuchtungseinrichtung mit einer Intensität von nur 25 % betrieben wird und diese erhöht werden soll, kann auch vorgesehen werden, für diejenigen Fälle, bei denen die Beleuchtungseinrichtung bereits eingeschaltet ist, die aktuelle Ansteuerung als Einstellwert für die Einstiegsposition eines Gestikgebers 9 zu verwenden. Bei dem vorbeschriebenen Ausführungsbeispiel wäre somit der Einstellwert als Einschaltintensität dann 25 % der Intensität.

In Abhängigkeit von der Einstiegsposition G₁ und dem jeweiligen Einstellwert kann es vorkommen, dass auf einer der beiden in Bezug auf die Einstiegsposition und den Einstellwert eingerichteten Stellrampen diese relativ steil ist bzw. zu steil ist, um zielgerichtet die gewünschte Intensität auf dieser Stellrampe einstellen zu können. Bei einer intuitiven Bewegung des Gestikgebers 9 entlang einer solchen Rampe wird ein Benutzer eine besonders rasche Intensitätsänderung feststellen und mit hoher Wahrscheinlichkeit über den gewünschten Einstellwert auf der Gestenbahn 6 den Gestikgeber 9 hinwegführen. Bei dem beschriebenen Ausführungsbeispiel ist daher vorgesehen, dass bei Feststellen einer Änderung in der Bewegungsrichtung, wobei es sich bei dem dargestellten Ausführungsbeispiel um Feststellen einer Bewegungsumkehr des Gestikgebers 9 handelt, dieser Punkt der Bewegungsumkehr eine neue Einstiegsposition darstellt mit der Folge, dass entsprechend dem dann vorliegenden Einstellwert neue Stellrampen eingerichtet werden. Dieses bewirkt, dass sich dann der gewünschte Einstellwert auf einer Stellrampe befindet, die eine in aller Regel deutlich geringere Steilheit aufweist. Zum Bewirken einer Intensitätsänderung muss daher bei der Rückbewegung des Gestikgebers 9 ein entsprechend größerer Bewegungsbetrag zurückgelegt werden. Mithin lässt sich dann die gewünschte Intensität zielgerichteter einstellen.

Typischerweise sind geeignete Kontrollalgorithmen: in der Auswertung der Bewegung des Gestikgebers 9 vorgesehen, um eine solche gewünschte Bewegungsumkehr des Gestikgebers 9 von unerwünschten zu unterscheiden. Unerwünschte Bewegungsumkehrungen resultieren beispielsweise dadurch, dass der Gestikgeber 9 nicht ruhig gehalten wird oder gehalten werden kann, beispielsweise durch ein gewisses Zittern.

Eine solche Verfahrensweiterbildung ist in dem Diagramm der Figur 2 unten visualisiert. Ausgehend von der Einstiegsposition G₁ des Gestikgebers 9 soll die Beleuchtungseinrichtung soll die Beleuchtungseinrichtung auf eine gewünschte Intensität von etwa 50 % gedimmt werden. Der Nutzer bewegt den Gestikgeber 9 unter Berücksichtigung dieser Zielvorgabe intuitiv von der Wand bzw. der Abdeckung 4 weg. Die sich aufgrund der Steilheit der Stellrampe S₂ ergebende Intensitätsänderung erfolgt rasch, sodass der Nutzer seine Hand als Gestikgeber 9 über die gewünschte Intensität von 50 % hinaus bewegt, und zwar bei dem dargestellten Ausführungsbeispiel bis zu der Position G₂ auf der Gestenbahn 6. Die Intensität in Bezug auf die Position G₂ des Gestikgebers 9 liegt deutlich unterhalb der gewünschten 50 %-Intensität, vielleicht etwa bei etwa 15 %. Dieser Punkt ist mit I₂ auf der Stellrampe S₂ kenntlich gemacht. Ebenso wie bei dem Intensitätswert I₁ werden nunmehr neue Stellrampen S₁', S₂' bereitgestellt, die diesen neuen Einstellwert als Einschaltintensität I₂ mit den Endpunkten X_{A}, X_{E} verbinden. Die Stellrampe S₁' verbindet den Intensitätspunkt I₂ mit dem Maximalintensitätswert an dem diesbezüglichen Endpunkt X_{A} der Gestenbahn 6; die Stellrampe S₂' verbindet den Intensitätspunkt I₂ mit dem Minimalintensitätspunkt an dem diesbezüglichen Endpunkt X_{E} der Gestenbahn 6. Der Steigungswinkel der Stellrampe S₂' entspricht naturgemäß derjenigen der Stellrampe S₂. Getriggert wird das neue Bereitstellen der Stellrampen dadurch, dass der Gestikgeber 9 hinsichtlich seiner Bewegungsrichtung umgekehrt worden ist und über eine gewisse Mindestdistanz in der Umkehrrichtung bewegt worden ist. Eine Rückbewegung des Gestikgebers 9 wiederum in Richtung zu der Abdeckung 4 hin führt sodann zu einer Intensitätsänderung nicht mehr auf der Stellrampe S₂, sondern auf der Stellrampe S₁'. Diese weist einen deutlich geringeren Steigungswinkel auf als die Stellrampe S₂. Der Gestikgeber 9 muss zum Erreichen der gewünschten Dimmstellung (50 % der Intensität) bei dieser Rückbewegung viel weiter bewegt werden als bei der Hinbewegung. Mithin kann auf die durch Bewegen des Gestikgebers 9 bewirkte Intensitätsänderung in der Beleuchtungseinrichtung besser reagiert werden. Die gewünschte Dimmstellung ist in der Position G₃ auf der Gestenbahn 6 erreicht. Diese Position liegt, wie aus Figur 2 erkennbar, noch näher an dem Sensor 3 auf der Gestenbahn 6 als die Einstiegsposition G₁. Ist die gewünschte Dimmstellung - die Position G₃ - mit dem Gestikgeber 9 erreicht, wird ein Halte-Signal erzeugt, damit die Beleuchtungseinrichtung fortan mit diesem Einstellwert I₃ angesteuert wird. Erzeugt werden kann ein solches Halte-Signal auf unterschiedliche Weise, beispielsweise durch
- Halten der Stellung des Gestikgebers 9 für eine ein vorgegebenes Zeitintervall überschreitende Zeitspanne,
- Herausbewegen des Gestikgebers 9 aus der Gestenbahn 6 in Querrichtung hierzu,
- kurzzeitige Bewegungsumkehr in der Bewegung des Gestikgebers 9 entlang der Gestenbahn,
- rasches Bewegen des Gestikgebers 9, vorzugsweise in einer anderen Bewegungsrichtung als in der Gestenbahn 6.

Bei dem vorbeschriebenen Ausführungsbeispiel ist vorgesehen, dass zum Erzeugen eines Halte-Signals der Gestikgeber 9 rasch in Querrichtung zu der Bewegungsbahn 6 aus dem Erfassungsbereich 5 des Sensors 3 herausbewegt wird.

Bei der beschriebenen Ausgestaltung ist vorgesehen, dass die erste Bewegungsumkehr des Gestikgebers 9 durch die neue Einstiegsposition G₂ und damit den Einstellwert I₂ bzw. die hierauf aufbauenden Stellrampen definiert ist. Durchaus möglich ist auch eine Ausgestaltung, bei der dieses auch erst bei der zweiten Bewegungsumkehr oder noch einer späteren vorgenommen wird. In noch einer weiteren Ausgestaltung ist vorgesehen, dass anstelle des Detektierens einer Bewegungsrichtungsänderung, beispielsweise einer Bewegungsumkehr, bei Bewegen des Gestikgebers 9 ausgehend von der ersten Einstiegsposition G₁ in Richtung von der Abdeckung 4 weg, das Verlassen des Erfassungsbereiches durch den Gestikgeber 9, also: das Überschreiten des Endpunktes X_{E} der Gestenbahn 6, als neue Einstiegsposition verwendet wird. Es versteht sich, dass dieses vorgenommen wird, wenn nicht innerhalb eines vorgesehenen Zeitintervalls der Gestikgeber 9 auf der Gestenbahn 6 in die umgekehrte Richtung zurückbewegt wird, mithin wieder in den Erfassungsbereich 5 des Sensors 3 eintritt.

In noch einer weiteren Verfahrensausgestaltung ist vorgesehen, dass nicht nur nach einer solchen ersten Bewegungsumkehr in der Bewegung des Gestikgebers 9 auf der Gestenbahn 6 eine neue Einstiegsposition definiert wird, sondern auch bei einer nachfolgenden, beispielsweise der unmittelbar nachfolgenden Bewegungsumkehr.

Bei dem beschriebenen Ausführungsbeispiel ist vorgesehen, dass auf der Gestenbahn 6 der Maximalwert sich an dem sensorseitigen Ende der Gestenbahn 6 befindet und umgekehrt der Minimalintensitätswert an dem anderen Ende. Dieses kann auch umgekehrt vorgesehen sein. Des Weiteren sind Ausgestaltungen möglich, bei denen die Maximal- oder Minimalstellung sich innerhalb der Gestenbahn 6 befindet und in den Enden der Gestenbahn der jeweils andere Wert positioniert ist.

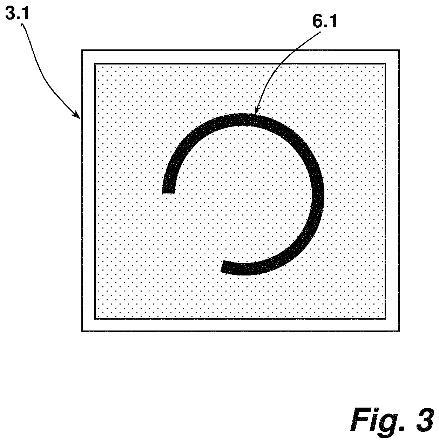

Die Beschreibung des Verfahrens zum Ansteuern der Beleuchtungseinrichtung verdeutlicht, dass es sich bei der angesteuerten Last, hier: der Beleuchtungseinrichtung, nur um eine beispielhafte elektrische Last handelt und, dass sich dieses Verfahren auf eine Vielzahl anderer elektrischer Lasten anwenden lässt. Darüber hinaus wird deutlich, dass die Ansteuerung und insbesondere die Einstellung (das Dimmen) der elektrischen Last intuitiv möglich sind und, dass sich dieses Verfahren letztendlich auf jedwede Bewegungsbahn anwenden lässt. Daher eignet sich das vorbeschriebene Verfahren nicht nur für die Ansteuerung einer elektrischen Last, also beispielsweise einer Beleuchtungseinrichtung im Rahmen einer Gebäudeinstallation, bei der die Gestenbahn 6 orthogonal zur Ebene des Gestenerkennungssensors 3 verläuft, sondern auch für Gestenbahnen, die in der Ebene des Gestenerkennungssensors verlaufen. In Figur 3 ist beispielhaft eine andere Gestenbahn 6.1 auf der sensitiven Seite eines Gestenerkennungssensors 3.1 dargestellt. Bei dieser Gestenbahn 6.1 handelt es sich um eine Teilkreisbahn. Auch bezüglich dieser stellt der Aufsetzpunkt des Gestikgebers die Einstiegsposition dar. Selbstverständlich sind auch andere bogenfömige oder translatorische Gestenbahnen 6.1 möglich. Sollen die Gestenbahnen 6.1 in der Ebene des Gestenerkennungssensors 3.1 verlaufen, versteht es sich, dass hier Flächensensoren erforderlich sind, wie dieses bei dem Sensor 3.1 der Fall ist. Im Falle einer orthogonal zu dem Sensor 3.1 verlaufenden Gestenbahn 6.1, wie dieses zu dem Ausführungsbeispiel der Figuren 1 und 2 beschrieben ist, ist dieses prinzipiell nicht erforderlich. Hierfür ist es ausreichend, einen Sensor 3.1 einzusetzen, der keine Auflösung über seine Fläche aufweist. Somit kann anstelle des in dem Ausführungsbeispiel konkret beschriebenen Gestenerkennungssensors 3.1 auch beispielsweise ein IR-Abstandssensor oder jedweder andere Abstandssensor eingesetzt werden.

Mit dem Gestenerkennungssensor 3 des beschriebenen Ausführungsbeispiels und mit solchen Gestenerkennungssensoren, die nicht nur eine Ortsauflösung in der Fläche des Sensors, sondern auch eine Abstandsinformation erlauben, lassen sich Tiefenkarten des Gestikgebers erstellen. Bei einem solchermaßen ausgelegten Gestenerkennungssensor kann eine Umschaltung zwischen unterschiedlichen Ansteuermenüs erfolgen. Befindet sich die Gestenbahn beispielsweise in der Erfassungsebene des Sensors, kann eine Umschaltung in unterschiedliche Menüpunkte durch unterschiedlichen Abstand des Gestikgebers von der Erfassungsebene getriggert werden. Bei einer solchen Ausgestaltung, bei der unterschiedliche Menüebenen bzw. Menüpunkte angesteuert werden können, können diese dazu dienen, ein und dieselbe elektrische Last in unterschiedlicher Weise anzusteuern. Bei einer Beleuchtungseinrichtung lassen sich in unterschiedlichen Menüpunkten beispielsweise unterschiedliche Lichtszenen realisieren, die dann in dem jeweiligen Menüpunkt durch Bewegen des Gestikgebers auf einer anderen Gestenbahn gedimmt werden können. In unterschiedlichen Menüpunkten lassen sich auch verschiedene elektrische Lasten, also: auch beispielsweise mehrere unabhängig voneinander angesteuerte Leuchten ansteuern. Gemäß einem Ausführungsbeispiel ist dann vorgesehen, dass jeweils ein Menüpunkt einer Leuchte zugeordnet ist. In dem angesteuerten Menüpunkt kann diese Leuchte dann je nach Ausrichtung gedimmt oder in unterschiedliche Lichtszenen geschaltet werden. Sind in einem Menüpunkt unterschiedliche Lichtszenen ansteuerbar, bietet es sich für eine solche Ausgestaltung an, die Stellrampen stufig auszubilden, wobei jeder Stufe einer Lichtszene zugeordnet ist.

Die vorstehend beispielhaften Ausführungsbeispiele verdeutlichen, dass mit dem beschriebenen Verfahren eine Vielzahl unterschiedlicher Ansteuermöglichkeiten eingestellt werden können. Von besonderem Vorteil ist hierbei auch, dass die Gestenbahnen und auch die Stellrampen ohne weiteres umprogrammiert werden können, so dass eine einmal vorgenommene Einrichtung problemlos geändert werden kann. Angesteuert kann diesbezüglich ein solcher Sensor, der zu diesem Zweck typischerweise an ein Bussystem angeschlossen ist, über die Bussteuereinrichtung.

Angeschlossen werden kann ein solcher Sensor an einen Gebäudeinstallationsbus über eine Leitung (Draht) oder auch drahtlos.

In den vorbeschriebenen Ausführungsbeispielen wurde unterstellt, dass der Gestikgeber nach Einrichten der Ansteuerung der elektrischen Last und Generieren eines Halte-Signals aus dem Erfassungsbereich des Sensors herausgebracht wird. Durchaus besteht auch die Möglichkeit, dass der Gestikgeber, ohne ein Halte-Signal erzeugt zu haben, den Erfassungsbereich des Sensors verlässt. Tritt der Gestikgeber innerhalb einer vordefinierten Zeitspanne in den Erfassungsbereich wieder ein, kann vorgesehen sein, dass dieses keine neue Einstiegsposition definiert, sondern die Einstellungsänderung gemäß den zuvor eingerichteten Stellrampen vorgenommen wird. Auf diese Weise kann eine Gestenbahn auch zyklisch durchlaufen werden.

Mit einem geeigneten Algorithmus wird zweckmäßigerweise eine Filterung vorgenommen, um ungewünschte Betätigungen der mit dem Gestenerkennungssensor angesteuerten Last von gewünschten Ansteuerungsmaßnahmen zu unterscheiden. Beispielsweise kann dieses bewirkt werden, dass für eine gewisse Zeitspanne hin ein gewisser Flächenanteil des Erfassungsbereiches des Gestenerkennungssensors von dem Gestikgeber bedeckt sein muss. Durch diese Maßnahme werden Bewegungen, die durch den Erfassungsbereich des Sensors erfolgen und diesen naturgemäß zeitweise abdecken, möglicherweise sogar vollständig, von solchen Gesten unterschieden, die tatsächlich einer Einstellung der über den Sensor angesteuerten Last dienen sollen.

### Bezugszeichenliste

- 1: Türdurchbruch
- 2: Wand
- 3, 3.1: Sensor
- 4: Abdeckung
- 5: Erfassungsbereich
- 6,6.1: Gestenbahn
- 7: Erfassungsebene
- 8: Oberfläche
- 9: Gestikgeber
- G₁, G₂, G₃: Position auf Gestenbahn
- I₁, I₂, I₃: Einschaltintensität
- S₁, S₁', S₂, S₂': Stellrampe

## Patentansprüche

1. Verfahren zum Ansteuern einer elektrischen Last, beispielsweise einer Beleuchtungseinrichtung einer Gebäudeinstallation, mittels eines berührungslos arbeitenden Gestenerkennungssensors (3, 3.1), umfassend folgende Schritte:
- Erfassen eines in den Erfassungsbereich (5) des Gestenerkennungssensors (3, 3.1) hineinbewegten Gestikgebers (9),
- Ansteuern der zu bedienenden elektrischen Last mit einem vorgegebenen Einstellwert (I₁),
- Erfassen einer Positionsänderung des Gestikgebers (9) entlang einer Gestenbahn (6, 6.1) in einer ersten Richtung, durch welche Bewegung des Gestikgebers (9) die elektrische Last entsprechend der für diese Richtung eingerichteten Stellrampe (S₁, S₂) in seiner Einstellung geändert wird,
- Halten der aktuellen Einstellung der elektrischen Last, wenn ein durch den Gestikgeber (9) erzeugtes Halte-Signal erfasst wird,
**gekennzeichnet durch**
- Bestimmen der Einstiegsposition (G₁) des erfassten Gestikgebers (9) auf einer für die Ansteuerung der elektrischen Last vorgesehenen und auf die Ebene des Gestenerkennungssensors (3, 3.1) projizierte Bahn, entlang der der Gestikgeber (9) zum Ändern der aktuellen Einstellung der elektrischen Last bewegt werden muss - d.h. der Gestenbahn (6, 6.1) - und
- Bereitstellen jeweils einer Stellwertskennlinie von einem vorgegebenen Einstellwert zu einem Minimalwert oder zu einem Maximalwert - einer Stellrampe (S₁ bzw. S₂) - von dem vorgegebenen Einstellwert zu einem Minimalwert sowie von dem vorgegebenen Einstellwert zu einem Maximalwert in Abhängigkeit von einer Einstiegsposition (G₁) des Gestikgebers (9) auf der Gestenbahn (6, 6.1).

2. Verfahren nach Anspruch 1, **dadurch gekennzeichnet, dass** bei Feststellen einer Änderung in der Bewegungsrichtung des Gestikgebers (9) bei dem Vorgang des Änderns der Einstellung der elektrischen Last die Position der Bewegungsrichtungsänderung auf der Gestenbahn (6, 6.1) eine neue Einstiegsposition (G₂) darstellt und ausgehend von dem dieser neuen Einstiegsposition (G₂) entsprechenden Einstellwert (I₂) jeweils eine Stellrampe (S₂' bzw. S₁') zu dem Minimalwert und zu dem Maximalwert eingerichtet werden und dass bei weiterem Bewegen des Gestikgebers (9) in der geänderten Bewegungsrichtung die Einstellung der elektrischen Last entsprechend der neu eingerichteten Stellrampe (S₁') geändert wird.

3. Verfahren nach Anspruch 2, **dadurch gekennzeichnet, dass** bei Feststellen einer erneuten Änderung in der Bewegungsrichtung des Gestikgebers (9) bei dem Vorgang des Änderns der Einstellung der elektrischen Last die Position der Bewegungsrichtungsänderung auf der Gestenbahn (6, 6.1) eine neue Einstiegsposition darstellt und ausgehend von dem dieser neuen Einstiegsposition entsprechenden Einstellwert jeweils eine Stellrampe zu dem Minimalwert und zu dem Maximalwert eingerichtet werden und dass bei weiterem Bewegen des Gestikgebers (9) in der geänderten Bewegungsrichtung die Einstellung der elektrischen Last entsprechend der neu eingerichteten Stellrampe geändert wird.

4. Verfahren nach Anspruch 2 oder 3, **dadurch gekennzeichnet, dass** die Änderung in der Bewegungsrichtung des Gestikgebers (9) eine Bewegungsumkehr auf der Gestenbahn (6, 6.1) ist.

5. Verfahren nach einem der Ansprüche 1 bis 4, **dadurch gekennzeichnet, dass** in Abhängigkeit des Betrages der Positionsänderung des Gestikgebers (9) gegenüber der jeweils aktuellen Einstiegsposition auf der Gestenbahn (6, 6.1) die Einstellung der elektrischen Last mit unterschiedlicher Geschwindigkeit erfolgt.

6. Verfahren nach Anspruch 5, **dadurch gekennzeichnet, dass** bei betragsmäßig kleineren Positionsänderungen die Einstellgeschwindigkeit geringer ist als bei größeren betragsmäßigen Positionsänderungen.

7. Verfahren nach einem der Ansprüche 1 bis 6, **dadurch gekennzeichnet, dass** die Gestenbahn (6) zum Bewirken einer Änderung in der Einstellung der elektrischen Last eine den Abstand des Gestikgebers (9) gegenüber dem Gestenerkennungssensor (3) ändernde Bahn ist.

8. Verfahren nach einem der Ansprüche 1 bis 6, **dadurch gekennzeichnet, dass** der Gestenerkennungssensor (3.1) als Flächensensor ausgelegt ist und die Gestenbahn (6.1) zum Bewirken einer Änderung in der Einstellung der elektrischen Last parallel zur Ebene des Sensors (3.1) verläuft.

9. Verfahren nach einem der Ansprüche 1 bis 8, **dadurch gekennzeichnet, dass** das von dem Gestikgeber (9) erzeugte Halte-Signal eines oder mehrere der folgenden Signale ist:
- Halten der Stellung des Gestikgebers (9) für eine ein vorgegebenes Zeitintervall überschreitende Zeitspanne,
- Herausbewegen des Gestikgebers (9) in Querrichtung aus der Gestenbahn (6, 6.1),
- kurzzeitige Bewegungsumkehr in der Bewegung des Gestikgebers (9) entlang der Gestenbahn (6, 6.1),
- rasches Bewegen des Gestikgebers (9).

10. Verfahren nach einem der Ansprüche 1 bis 9, **dadurch gekennzeichnet, dass** als Gestenerkennungssensor (3, 3.1) ein 3D-Sensor verwendet wird und die Gestenbahn (6, 6.1) entweder ortsaufgelöst auf der Fläche des Sensors (3, 3.1) oder als Abstandsbahn hierzu verläuft und dass in einer anderen Erfassungsrichtung des Sensors (3, 3.1) durch Bewegen des Gestikgebers (9) unterschiedliche Menüpunkte zur Ansteuerung ein und derselben elektrischen Last und/oder zur Ansteuerung unterschiedlicher elektrischer Lasten ausgewählt werden können.

11. Verfahren nach einem der Ansprüche 1 bis 10, **dadurch gekennzeichnet, dass** als Gestenerkennungssensor (3, 3.1) ein elektrischer Nahfeldsensor eingesetzt wird.

## Claims

1. Process to control an electrical load, for instance a lighting unit in a building installation system, by means of a contact-free operating gesture detection sensor (3, 3.1), comprising the following steps:
- Detection of an object (9) being moved into the detection range (5) of the gesture detection sensor (3, 3.1),
- Control of the electrical load to be operated with a setpoint (I₁),
- Detection of a position change of the object (9) along the detection path (6, 6.1) in a first direction, by this movement of the object (9) the setting of the electrical load is changed according to the setting ramp (S₁, S₂) set for this direction,
- Holding of the current setting of the electrical load if a holding signal generated by the object (9) is detected,
**characterized by**
- Defining of the start position (G₁) of the detected object (9) on a path provided for the control of the electrical load and projected on the level of the gesture detection sensor (3, 3.1), along which the object (9) must be moved to change the current setting of the electrical load - i.e. the detection path (6, 6.1) - and
- Providing one setpoint characteristic each from a given setpoint to a minimum value or to a maximum value - a setpoint ramp (S₁ or S₂) - from the given setpoint to a minimum value as well as from the given setpoint to a maximum value depending on the start position (G₁) of the object (9) on the detection path (6, 6.1).

2. Process in accordance with Claim 1, **characterized by the fact** that on detection of a change in the movement direction of the object (9) in the process of changing the setting of the electrical load, the position of the change of movement direction on the detection path (6, 6.1) represents a new start position (G₂) and based on the setpoint (I₂) corresponding to this new start position (G₂) one setting ramp each (S₂' bzw. S₁') to the minimum value and to the maximum value will be set and that with further movement of the object (9) in the changed movement direction the setting of the electrical load will be changed according to the newly set setting ramp (S₁').

3. Process in accordance with Claim 2, **characterized by the fact** that on detection of a renewed change of the movement direction of the object (9) in the process of changing the setting of the electrical load the position of the change of movement direction on the detection path (6, 6.1) signifies a new start position and based on the setpoint corresponding to this new start position one setting ramp each to the minimum value and to the maximum value will be set and that with further movement of the object (9) in the changed movement direction the setting of the electrical load will be changed according to the newly set setting ramp.

4. Process in accordance with Claims 2 or 3, **characterized by the fact** that the change in the movement direction of the obejct (9) is a reversal of movement on the detection path (6, 6.1).

5. Process in accordance with any of Claims 1 to 4, **characterized by the fact** that depending on the rate of position change of the object (9) compared to the current start position on the detection path (6, 6.1), the setting of the electrical load is effected with different speeds.

6. Process in accordance with Claim 5, **characterized by the fact** that in case of lower-rate position changes the setting speed is lower than in case of larger-rate position changes.

7. Process in accordance with any of Claims 1 to 6, **characterized by the fact** that the detection path (6), for effecting a change in the setting of the electrical load, is a path changing the distance of the object (9) to the gesture detection sensor (3).

8. Process in accordance with any of Claims 1 to 6, **characterized by the fact** that the gesture detection sensor (3.1) is designed as surface sensor and the detection path (6.1), to effect a change in the setting of the electrical load, runs parallel to the level of the sensor (3.1).

9. Process in accordance with any of Claims 1 to 8, **characterized by the fact** that the stop signal generated by the object (9) is one or several of the following signals:
- Holding the position of the object (9) for a time exceeding a preset time interval,
- Moving the object (9) out of the detection path (6, 6.1) in cross direction,
- Short-time reversal of the movement of the object (9) along the detection path (6, 6.1),
- Fast movement of the object (9).

10. Process in accordance with any of Claims 1 to 9, **characterized by the fact** that a 3D-sensor is used as gesture detection sensor (3, 3.1) and the detection path (6, 6.1) runs either spacially resolved on the surface of the sensor (3, 3.1) or as distance path to the same and that in another detection direction of the sensor (3, 3.1) by movement of the object (9) different menu items for control of the same electrical load and/or for control of different electrical loads can be selected.

11. Process in accordance with any of Claims 1 to 10, **characterized by the fact** that an electric close-range sensor is used as gesture detection sensor (3, 3.1).

## Revendications

1. Procédé pour solliciter une charge électrique, par exemple une installation d'éclairage d'une installation de bâtiment, moyennant un capteur de détection de gestes (3, 3.1) fonctionnant sans contact, comprenant les étapes suivantes :
- détecter un transmetteur de gestes (9) introduit dans la zone de détection (5) du capteur de détection de gestes (3, 3.1)
- solliciter la charge électrique à commander à une valeur de réglage (I₁) prédéfinie,
- détecter un changement de position du transmetteur de gestes (9) le long d'une voie de gestes (6, 6.1) dans une première direction, déplacement du transmetteur de gestes (9) à travers lequel la charge électrique est changée dans son réglage conformément à la rampe de réglage (S₁, S₂) réglée pour cette direction,
- maintenir le réglage actuel de la charge électrique lorsqu'un signal d'arrêt généré par le transmetteur de gestes (9) est détecté,
**caractérisé en ce que**
- la détermination de la position d'entrée (G₁) du transmetteur de gestes (9) détecté sur une voie prévue pour la sollicitation de la charge électrique et projetée sur le plan du capteur de détection de gestes (3, 3.1) et le long de laquelle le transmetteur de gestes (9) doit être déplacé pour changer le réglage actuel de la charge électrique - c'est-à-dire la voie de gestes (6, 6.1) - et
- mise à disposition respectivement d'une courbe caractéristique de la valeur de réglage d'une valeur de réglage prédéfinie à une valeur minimale ou une valeur maximale - une rampe de réglage (S₁ voire S₂) - de la valeur de réglage prédéfinie à une valeur minimale ainsi que de la valeur de réglage prédéfinie à un valeur maximale en fonction d'une position d'entrée (G₁) du transmetteur de gestes (9) sur la voie de gestes (6, 6.1).

2. Procédé selon la revendication 1, **caractérisé en ce que,** lors de la détection d'un changement dans la direction du déplacement du transmetteur de gestes (9) dans le processus de changement du réglage de la charge électrique, la position de changement du déplacement sur la voie de gestes (6, 6.1) représente une nouvelle position d'entrée (G₂) et qu'en partant de cette valeur de réglage (I₂) correspondant à cette nouvelle position d'entrée (G₂), respectivement une rampe de réglage (S₂' voire S₁') est réglée à la valeur minimale et à la valeur maximale et que lors d'un déplacement continu du transmetteur de gestes (9) dans la direction de déplacement changée, le réglage de la charge électrique est changé en fonction de la rampe de réglage (S₁') nouvellement réglée.

3. Procédé selon la revendication 2, **caractérisé en ce que,** lors de la détection d'un nouveau changement dans la direction du déplacement du transmetteur de gestes (9) dans le processus de changement du réglage de la charge électrique, la position de changement du déplacement sur la voie de gestes (6, 6.1) représente une nouvelle position d'entrée et qu'en partant de cette valeur de réglage correspondant à cette nouvelle position d'entrée respectivement une rampe de réglage est réglée à la valeur minimale et à la valeur maximale et que lors d'un déplacement continu du transmetteur de gestes dans la direction de déplacement changée, le réglage de la charge électrique est changé en fonction de la rampe de réglage nouvellement réglée.

4. Procédé selon la revendication 2 ou 3, **caractérisé en ce que** le changement dans la direction de déplacement du transmetteur de gestes (9) est un inversement du déplacement sur la voie des gestes (6, 6.1).

5. Procédé selon l'une des revendications 1 à 4, **caractérisée en ce que** le réglage de la charge électrique est effectué à des vitesses différentes en fonction de l'importance du changement de la position du transmetteur de gestes (9) par rapport à la position d'entrée respectivement actuelle sur la voie des gestes (6, 6.1).

6. Procédé selon la revendication 5, **caractérisé en ce que,** lors de changements d'une moindre importance de la position, la vitesse de réglage est inférieure aux changements d'une importance plus grande de la position.

7. Procédé selon l'une des revendications 1 à 6, **caractérisé en ce que** la voie de gestes (6) pour effectuer un changement dans le réglage de la charge électrique est une voie changeant l'écart du transmetteur de gestes (9) par rapport au capteur de détection de gestes (3).

8. Procédé selon l'une des revendications 1 à 6, **caractérisé en ce que** le capteur de détection de gestes (3.1) est prévu comme capteur de surface et que la voie de gestes (6.1) s'étend parallèlement au plan du capteur (3.1) pour effectuer un changement dans le réglage de la charge électrique.

9. Procédé selon l'une des revendications 1 à 8, **caractérisé en ce que** le signal d'arrêt généré par le transmetteur de gestes (9) est l'un ou plusieurs des signaux suivants :
- maintenir la position du transmetteur de gestes (9) pendant un laps de temps dépassant un intervalle de temps prédéfini,
- sortir le transmetteur de gestes (9) dans la direction transversale en dehors de la voie de gestes (6, 6.1),
- inversement du déplacement pour une courte durée dans le déplacement du transmetteur de gestes (9) le long de la voie de gestes (6, 6.1),
- déplacement rapide du transmetteur de gestes (9).

10. Procédé selon l'une des revendications 1 à 9, **caractérisé en ce qu'**un capteur 3D est utilisé comme capteur de détection de gestes (3, 3.1) et que la voie de gestes (6, 6.1) s'étend ou bien indépendamment du lieu sur la surface du capteur (3, 3.1) ou comme voie d'écart et que dans une autre direction de détection du capteur (3, 3.1) le déplacement du transmetteur de gestes (9) permet de sélectionner des index différents du menu afin de solliciter la même charge électrique et / ou afin de solliciter des charges électriques différentes.

11. Procédé selon l'une des revendications 1 à 10, **caractérisé en ce qu'**un capteur électrique de champ proche est utilisé comme capteur de détection de gestes (3, 3.1).
